# EUROPEAN PATENT APPLICATION

(11) **EP 1 220 222 A1**
(43) Date of publication of application: **03.07.2002**
(21) Application number: 00902218.7
(22) Date of filing: 18.01.2000
(51) Int. Cl.: G11B 31/00, G11C 7/24, H04B 5/06

(54) **MOBILE KARAOKE SYSTEM, METHOD FOR ENSURING ELECTROMAGNETIC COMPATIBILITY OF SAID KARAOKE SYSTEM, MOBILE WIRELESS TRANSMITTER FOR SAID SYSTEM, METHOD FOR PREVENTING THE USE OF UNAUTHORIZED CARTRIDGES AND RESTRAINING UNAUTHORIZED ACCESS TO SAID SYSTEM**

(30) Priority: 20.09.1999 RU 99119818
(71) Applicant: Rovner, Yakov Shoel-Berovich, Moskovskaya obl., 140001 (RU); Agadzhanova, Marina Alexeevna, Moscow, 109147 (RU)
(72) Inventor: Rovner, Yakov Shoel-Berovich, Moskovskaya obl., 140001 (RU); Agadzhanova, Marina Alexeevna, Moscow, 109147 (RU)
(74) Representative: Staudt, Hans-Peter, Dipl.-Ing.
(86) International application number: RU0000009
(87) International publication number: WO0122419

(57) **Abstract**

Mobile karaoke system shall mix signal from external audio input, such as voice of a singer who performs a song to a microphone, with musical accompaniment data that is pre-stored in ROM package and generates a signal for transmission to a radio. The specific feature of this technical approach is that the mobile wireless transmitter for karaoke system shall be upgraded with auxiliary decoder for communication with cartridge via interface connector, and the cartridge is equipped with key identification and coding device that is linked to the Read-Only-Memory and can communicate with auxiliary decoder of the transmitter via interface connector.

Transmission to the receiver shall be based either on optical signal, or ultrasonic acoustic signal, or radio frequency signal, which is transmitted either via electric and/or magnetic near field of antenna while radio waves emission is being suppressed, or while using such emission within vacant allocated band. This signal is converted at the point of reception into broadcast frequency band with further reception of this signal by standard home radio. Due to the above said, there shall be no possibility of unauthorized access to the data that is stored in cartridge ROM, besides, unauthorized (pirate) cartridges can not be used for karaoke system, therefore, the rights of music composers and the rights of legal owners of intellectual property shall be observed.

## Description

This invention shall be applied to mobile karaoke system, which enables a singer to perform vocal part to music accompaniment recorded to interchangeable cartridge, and which transmits the singer's performance and the recorded melody to a receiving device using wireless method of transmission.

It is common knowledge that the modern device for music accompaniment, which is usually called karaoke-system, is designed in the following way: words of the song that is performed by a singer to a microphone are presented via electronic sound system together with pre-recorded music accompaniment.

Usually karaoke-system shall include a player based on magnetic tape or compact discs for presentation of music accompaniment to songs. A person may enjoy himself performing a selected song while his voice is mixed via a microphone with presented music accompaniment. Karaoke-systems become popular with many people who wish to sing some songs to accompaniment of selected melody and to improve their performance.

At present many restaurants and bars arrange special karaoke parties, extra additions to prices are introduced for visitors, payment is increased either directly or indirectly, prices for alcoholic beverages are raised and that money is taken for the right to participate or just watch how other people use karaoke-system.

Standard karaoke-system that is used in many restaurants and bars shall include a microphone, wide-band stereo system with powerful amplifier, which is capable of mixing sounds, echo generator for improvement of singer's voice sound quality, individual controller that enables a singer to select a song, to provide synchronization with it, to control volume of microphone and volume of music, to adjust tempo and pitch of sound from the point where he or she is standing. This system provides for rather a wide choice of melodies.

In such a system microphone and controller shall transmit signals to stereo- system, which plays back the chosen accompaniment melody mixed with performer's voice that has been processed appropriately by the stereo system. Due to limited data volume at a tape-recorder or a disc, these karaoke-systems require participation of the third person (bartender, for example) to load the music accompaniment that has been chosen by the singer from a long list of melodies.

Some karaoke-systems also contain video monitors for display of song words for the singer to read them during performance (1).

It is possible to establish a karaoke-system for home use, if a person is able to combine the above mentioned components in one place. However, it will be rather expensive to buy every component for individual use.

Standard karaoke system is also rather large, if you take into account the components for storage of music compositions to provide for a choice of considerable number of songs, the stereo system with power amplifier for complete and effective mixing of sounds and the individual controller. The equipment dimensions and number of its components make it hard to be transported, and it is necessary to ensure standard power connection for the most of hardware types. The above said shall create strict limitations for the conditions of karaoke-system application.

Another desired sphere of karaoke-system use is connected with the demand that exists among many young people and that is the desire to choose a song and to control sound volume while driving a car. There is a possibility to connect required components of standard karaoke-system to a vehicle stereo system. However, it is not easy to transfer such system from one vehicle to another. Besides, microphone and musical data storage may operate with one system and may be incompatible with another.

One more desired sphere of karaoke-system application is conducting of street performances, festivals, picnics in the country or on a beach. But again dimensions of equipment and its components that are required for selection of desired melody and sound volume shall make such application rather difficult.

Besides, many houses have more than one karaoke-system. Usually there is a main system in such a house that incorporates individual karaoke-systems, which are connected by wire. Such a system is usually placed in the premises where guests are received - living-room or drawing-room. There may be also an extra karaoke-system that incorporates all system components and it may be established in a large external building. In particular, when'you invite too many guests who can hardly be accommodated in that room, it shall be desirable to have two karaoke-systems for singing performances in different rooms of your house where you have karaoke-systems. However, it shall require considerable volume of activities for wiring installation of two or more systems, and different systems usually don't have mounting hardware that provide for playback of performance in one system so that it can be listened through another system. Besides, if you use two systems it is desirable to combine their power supply in one room. In this case, there is considerable redundancy of electric wiring for two or more systems, and different systems do not usually have mounting hardware for integration of power supply for two systems.

Thus, there is a demand for a system that could get over the limitations of the existing systems as regards their dimensions, power supply and requirements to individual components, system that would be flexible for use of two nearby systems and that could be easily moved to any place where a person can stay without any restrictions as regards location.

Cost of such a system should not be extremely high so that the user could buy it at reasonable price for home application.

The above limitations shall be eliminated in a portable music system for karaoke that incorporates memory with interface to plug-in cartridges with musical accompaniment, scanning device for retrieval of musical accompaniment complete with decoder, radio-microphone and device for conversion and processing of input signal and playback musical accompaniment and for its further transmission to receiving device (2).

The memory in the known portable karaoke musical system (2) is ROM - Read-Only-Memory for storage of musical data portions and their respective numbers in the form of digital signals. The scanning device for retrieval of musical accompaniment complete with decoder contains a microprocessor for performance of pre-defined operations in compliance with a code stored in microprocessor memory. The operations are performed when input signals are received from Key Matrix. Besides, the microprocessor via multiplexer and decoder selects the musical data that is stored in memory.

In the known portable musical system for karaoke ROM package shall provide for storage of up to 1,200 songs. By plugging-in a music cartridge to the system interface a performer may select musical accompaniment from a long list without any limitations regarding the initial music version that is recorded into the system. Cartridges with recorded musical compositions can be available for sale so that the users may buy recordings of melodies that they like and can exchange them with their friends in order to expand the selection possibilities.

Cartridges that provide digital recording for storage of musical data are well-known (3).

Cartridge for portable musical system may incorporate Read-Only-Memory for storage of musical compositions and interface for connection to musical unit (4).

The drawback of the known devices, i.e. portable musical system for karaoke (2) and cartridge for portable musical system (4), is that the data being stored in ROM package, which includes pre-recorded musical compositions, is not protected against unauthorized use.

That brings violation of copyright that belongs to authors of the recorded music and to legal owners of intellectual property.

There is a portable musical karaoke system and cartridge for it, which shall provide certain protection for data that comprises recorded musical compositions.

In the known portable musical system for karaoke, which incorporates memory with interface for connection of music cartridges, scanning device for searching of musical accompaniment with decoder, microphone and device for conversion and processing of input and playback musical accompaniment and for its further transmission to a receiving device. There is also an auxiliary decoder for communication with cartridge through interface connector. In this case, the cartridge for portable musical system, which incorporates Read-Only-Memory for storage of musical compositions and interface for connection to musical device, shall be upgraded with key coding device that is integrated to ROM package and it shall be capable of communication with auxiliary decoder of portable musical system through its interface.

Further to the task to protect the cartridge data against unauthorized access there is still a challenge to prevent large-scale illegal manufacturing and use of cartridges or other storage media that are actually pirate copies of musical compositions. Availability and relatively low prices for memory chips of high capacity has aggravated this problem recently, especially, as regards portable musical karaoke devices that are made in the form of radio-microphone.

There is also a problem of electromagnetic compatibility between "karaoke radio-microphone" and existing radio broadcast and service communication transmitters, as well as systems that are sensitive to radio waves. On the one hand, for easier use of available FM radios it is desirable to receive a radio signal at the carrier frequency that lies in the band of 67-108 MHz. On the other hand, there are powerful broadcast transmitters that operate in the mentioned band, and the signal from "karaoke radio-microphone" should be rather powerful in order to be received at the acceptable level of signal/noise ratio. But it should not create interference for broadcasting and must not be received by those listeners who just happened to be in the area of "karaoke radio-microphone" operation. There are also legal restrictions concerning registration and use of any radio wave devices that operate within such bands.

Thus, there is a demand for mobile and, hence, wireless system, which could provide for exchange between receiving and transmitting devices without creating any interference on the air.

The purpose of the present invention is to solve the above mentioned problems. On the one hand, it shall provide for reliable and high-quality reception of information from karaoke transmitting device, and, on the other hand, it shall enable to avoid undesirable influence of karaoke signal to casual radio listeners, to prevent unauthorized access to protected data that contains musical accompaniment in the form of authorized data. Besides, it shall secure legal copyrights of musical composition authors, proprietary rights of intellectual property owners, and the market of music and entertainment industry shall become more "civilized".

System approach has been used in the present invention in order to settle the above mentioned problems. First, measures have been taken (and appropriate technical decisions have been developed for their implementation) to prevent undesirable radio emission by karaoke transmitter. Second, it has been proposed to use data exchange channels that were never used in such systems before - optical and ultrasonic channels. In contrast to radio waves the area of such channels operation can be limited easily and conveniently and that shall enable to prevent transmission of confidential and/or protected information to those receivers that are not included into the invited users of such information. It shall become easier to solve the problem of electromagnetic compatibility between radio transmitting, radio receiving and/or radio sensitive systems.

As opposed to radio channel, ultrasonic acoustic channel has almost no background (noise) component in the signal within the human inhabitance area. That is caused by absorption of ultrasonic signals in the air at high carrier frequencies. So, different ultrasonic transmitting & receiving systems, if distributed in space, have practically "no interference with each other", in contrast to radio systems.

There is an additional technical result of using ultrasonic channel for communication between transmitters and receivers of ultrasonic emission just in karaoke system. It results in the possibility to apply new sound effects due to the fact that the ultrasonic signal enables to use natural acoustics of the halls or rooms, to get "presence effect" even when listening to a singer's performance through ear-phones. Another technical result of using ultrasonic communication channel shall be the possibility to control device operation area via selection and/or adjustment of carrier frequency, as well as to prevent signal reception by listeners to other programs and/or singers. Besides, it shall be possible to use positively such features of ultrasonic communication channel that have been considered to be its drawbacks (low wave velocity as compared to radio waves and dramatic raise in ultrasonic waves attenuation level in the air when the carrier frequency of ultrasonic channel is increased).

Thus, the first subject of the present invention is mobile karaoke system that shall incorporate the following components:
- mobile wireless transmitter,
- collection of authorized legal cartridges with recorded musical accompaniment,
- mobile device for receiving of signals from the transmitter,
- mobile device for conversion of received signal into acoustic sound, In this case, the mobile wireless transmitter shall have the body that can be held, moved and controlled conveniently by a performer. Inside the body or on top of it there are the following components: microphone for input of acoustic signal, control panel, microprocessor, synthesizer that is integrated with the microprocessor, scanning device for searching of musical accompaniment with decoder, memory that is linked to interface connector via multiplexer for plugging-in one of many cartridges. It shall be made in the form of bed or socket that provide for convenient input and fixing of cartridge being plugged into interface connector. Further to the above mentioned, the body shall contain a device for conversion and processing of microphone signals and playback musical signal, device for generation of final output electric signal and for its further transmission in the form of modulated emission into surrounding space, auxiliary decoder for communication with cartridge via interface, which enables to recognize authorized legal cartridges that are protected against unauthorized access by authorized key code device with an access password. It shall prevent operation of mobile wireless transmitter with an unauthorized and/or illegal cartridge or any other information storage media that has no authorized key coding device with such access password. Besides, it shall have the possibility of information exchange with an authorized legal cartridge at the data exchange rate that shall be not less than in real time;
   Each cartridge that is included into the mentioned collection of authorized legal cartridges with pre-stored musical accompaniment shall contain Read-Only-Memory chips, which are linked to each other and to interface connector. The chips are used for storage of coded data of musical accompaniment. Besides, there are chips of authorized key identification and coding device with access password that are used to prevent unauthorized access to the data that is stored in Read-Only-Memory of the cartridge and to identify that such cartridge belongs to the above mentioned collection.

The first specific case of such a system shall be the mobile karaoke system as described above. In this system mobile wireless transmitter provides for the possibility to transmit modulated optical signal, and mobile receiver for signals emitted by the transmitter shall be arranged in the form of "n" optical receivers, where "n" is a whole number not less than 1.

The second specific case of such a system shall be the described mobile karaoke system where mobile wireless transmitter can transmit modulated acoustic ultrasonic signal and mobile receiver shall be arranged in the form of "n" ultrasonic receivers, where "n" is a whole number not less than 1.

The third specific case of such a system shall be the above-described mobile karaoke system where mobile wireless transmitter can transmit modulated radio signal in the first frequency band that is specially selected to ensure electromagnetic compatibility with other radio wave sources operating on the air as well as with any other devices that are sensitive to radio waves. Mobile receiver in such a system shall be arranged in the form of "n" converters/repeaters for further transmission of received signal in the second radio frequency band to "n" radio sets, where "n" is a whole number not less than 1.

In this case, it shall be preferred that the first frequency band is in the range of 26-30MHz and the second frequency band is in the range of 67-108MHz.

It shall be preferential that the described karaoke system has a mobile wireless transmitter that can transmit modulated radio signal on the carrier frequency f₀ that falls into the first band, and a receiver incorporates "n" individual converters/repeaters where "n" is a whole number not less than 1. The converter/repeater "i" ("i" is 1,2...n) can receive signals on the carrier frequency f₀ and can transmit them in the form of frequency-modulated radio signals on the carrier frequency fᵢ that fall into the second band. The converters/repeaters shall be located in "n" areas of consistent reception of transmitter signals, and the device used to convert the received radio signal into acoustic signal shall be arranged in the form of "n" domestic radio sets that can perform radio reception in the second band. In this case, radio set "i" (where "i" is 1,2..., n) shall be tuned to received carrier frequency of radio signal fᵢ that is radiated by converter/repeater "i" and this radio set shall be close to the latter.

Another specific case of such a system is the above-described mobile karaoke system where a mobile wireless transmitter can transmit modulated electromagnetic signal of near field, and a mobile receiver shall be arranged in the form of "n" electromagnetic converters of near field (where "n" is a whole number not less than 1) that are linked to "n" respective acoustical-electrical transducers/amplifiers.

Such system shall use component of electromagnetic field, which is detected only at distances comparable with the dimensions of antenna and/or elements that create magnetic and/or electric fields in the environment. It should be noted that the mentioned above component of electromagnetic field (irrespective of frequency band) is not electromagnetic wave: it shall diminish as the distance increases as per the same principle as constant or slowly varying field does. Due to this fact, that component shall not create interference to broadcasting even if this component frequency falls in the radio waves band that is allocated for radio broadcast and/or service communication. Interaction between "transmitter" and "receiver" in such system shall be effected as per the laws of electromagnetic and/or electrostatic induction; therefore, such system is, in some way, interim between wire and wireless communication.

Although this system is called a transmission system for electromagnetic signal of near field, communication via such system may be established for as long distances as it is wished. It could be achieved by arranging a chain of receivers and repeaters that in this case shall operate as waveguide elements, i.e. electromagnetic signal may be transmitted from one element to another one by one "over chain" if there are no detected radio waves in the environment. Elements of such a "chain", which have been called earlier as receivers/repeaters, can be both passive (having no power source) and active. A chain of high-quality resonators may be taken as an example of passive elements. Distances between the "nearby links" of such chain are much longer than the size of resonators themselves, but they are within the distance range where the component of near field can be detected. Then, whatever low is the factor of electromagnetic link between those elements, it is possible to establish channeling of electromagnetic power via chain of such resonators with efficiency as close to 1 (one). That can be achieved by selecting such resonators of rather high quality and by tuning them to resonance. But it shall mean that practically entire electromagnetic power is propagated along such chain (in theory, without any losses if elements are ideal) in the form of electromagnetic power of near field without radiation of electromagnetic waves into the environment.

The mentioned chain elements may be laid out in any configuration (if the purpose is not to transmit electromagnetic power to the maximum distance, but to provide, for example, maximum coverage area). The only requirement is to fulfil the following condition: any two random elements of such system shall be linked to each other by the near field signal either directly (for nearby links or elements) or via interim links or elements.

Actually, such technical approach shall enable to perform data exchange that combines the advantages of both wireless and wire communication (as regards mobility), as well as the advantages of cable communication (as regards electromagnetic compatibility, directivity of transmission to a specific consumer, protection of information against unauthorized listening and access, etc.).

So, in order to provide "sounding" for large premises, halls or squares it shall be enough to install many small active resonators/repeaters instead of laying broadcasting cables. The resonators/repeaters may be installed either in fixed position or on some mobile objects, their design shall be based on integrated circuits and they shall operate preferably in the near field.

Every user who has a mobile receiver (including common radio set) that is located in the vicinity of at least one of the mentioned resonators/repeaters may have access to transmitted information, although as a whole there may be no radio waves radiated into the air.

In order to expand functional features of karaoke transmitter, as well as in order to operate karaoke transmitters that have been manufactured without allowance for electromagnetic compatibility, or if there are any legal difficulties regarding registration of a radio source in the allocated frequency band, the karaoke transmitter may have additional device for locking of signal transmission in such frequency band (it is the second band according to the mentioned above terminology).

Taking into account the above said, the second subject of the present invention shall be the method to provide electromagnetic compatibility for mobile karaoke system. This method shall include the following steps. Musical data from memory with interchangeable cartridge is selected and decoded for obtaining of the first signal. Acoustic signal is received and converted through a microphone for obtaining of the second signal, then the first and second signals are processed. The resulting output electric signal is shaped and a radio signal is generated and radiated at the carrier frequency f₀ that falls into the first frequency band, which is allocated for free usage subject to limited radiation power. The radio signal is modulated by the above-mentioned resulting electric signal with given limited radiation power P₁. This radio signal is received in various "n" areas by "n" transceivers of the first type at frequency fᵢ that falls into the second band. The power of radiation here shall not be higher than kP₁ where k<0,1. The repeated signal is received independently in each area "i" ("i" = 1,2,..., n) at the carrier frequency fᵢ by radio receiver "i" of the second type. And, finally, the radio signal is converted to acoustic sound. It shall be preferred for the method of electromagnetic compatibility for mobile karaoke system that the first frequency band falls into the range of 26-30MHz and the second frequency band falls into the range of 67-108MHz.

In this case, the second type radio receiver "i" may be a standard home receiver with at least one of the following bands: 67-88MHz and 88-108MHz.

The version of choice for this method requires that the distance Lᵢ in each area between the respective devices of the first and second types should not exceed the maximum length of their antennas.

It shall be possible to transmit a signal from each device "i" of the first type to corresponding device "i" of the second type via electric and/or magnetic near field.

In this case, the first type devices can be made so that radio emission (of far field) is suppressed in them.

The third subject of the present invention is a mobile wireless transmitter for mobile karaoke system with a body that can be held, moved and controlled conveniently by a performer.

Inside the body or on top of it there are the following components: microphone for input of acoustic signal, control panel, microprocessor, sound synthesizer that is integrated with the microprocessor, scanning device for searching of music accompaniment with decoder, memory that is linked to interface connector via multiplexer for plugging-in one of many cartridges. It shall be made in the form of bed or socket that provide for convenient input and fixing of cartridge being plugged into interface connector. Further to the above mentioned, the body shall contain a device for conversion and processing of the signal received from microphone and the playback musical signal, device for shaping of the resulting output electric signal and for its further transmission in the form of modulated emission into surrounding space. The body shall also incorporate an auxiliary decoder for communication with cartridge via interface connector, which enables to recognize authorized legal cartridge that is protected against unauthorized access by authorized key code device with access password. It shall prevent operation of mobile wireless transmitter with unauthorized and/or illegal cartridge or any other information storage media that has no authorized key coding device with such access password.

As regards the first preferential option of mobile wireless transmitter for mobile karaoke system, transmission of its signals to the environment shall be effected in the form of electromagnetic emission in optical band, which may include infrared, visible or ultraviolet radiation.

As regards the second preferential option of mobile wireless transmitter for mobile karaoke system, transmission of its signals to the environment shall be effected in the form of ultrasonic acoustic emission.

As regards the third preferential option of mobile wireless transmitter for mobile karaoke system, transmission of its signals to the environment shall be effected in the form of radio waves within free allocated band that is not occupied by broadcast and service. communication transmitters.

There is one more possible option of wireless transmitter for mobile karaoke system. It shall be based on the use of electric and/or magnetic near field (of antenna) including the possibility to suppress-radio frequency emission.

The fourth subject of the present invention shall be a cartridge for mobile karaoke system. It has a body that can be inserted into the bed (into socket) of mobile karaoke transmitter and interface connector for plugging into the interface of mobile karaoke transmitter. Besides, there is Read-Only-Memory package for storage of data in the form of musical compositions and key identification and coding device in the form of microcontroller that is programmed accordingly. This device is linked to ROM package and it can communicate with auxiliary decoder of the mobile karaoke transmitter via interface connector to prevent unauthorized access to the data stored in ROM package and to provide for automatic cartridge identification through the mechanisms existing in mobile karaoke transmitter used to prevent input of data from any cartridge or data storage media that is not included in the collection of authorized legal cartridges. Chips of the above mentioned devices shall be mounted to printed circuit board inside the cartridge body.

There is a preferred option of cartridge where the coding and identification device is combined with the ROM package in the form of protected database with access password. Data exchange shall be activated only with the linked mobile karaoke transmitter, which contains the same access password in its auxiliary decoder.

The fifth subject of the present invention shall -be the method that prevents the use of unauthorized (illegal, pirate) cartridges and other data storage media in mobile karaoke system with a legal mobile karaoke transmitter. In compliance with this method, karaoke transmitter shall be upgraded with a device for cartridge identification as the one, which is included into the authorized collection of legal cartridges. Besides, the transmitter shall be equipped with a device that locks reception of data from the interface if it is detected that such interface is linked to unauthorized data storage media. And all cartridges that are included into the collection of authorized cartridges shall be supplied with key coding and identification device including access password.

The sixth subject of the present invention shall be the method to prevent unauthorized access, copying and use of data stored in the memory of any authorized legal cartridge for mobile karaoke system. In compliance with this method, mobile karaoke transmitter shall be upgraded with auxiliary decoder that can communicate with cartridge via interface connector, and each authorized legal cartridge shall be equipped with data protection capability. It is implemented as a key identification and coding device, which incorporates a microcontroller programmed appropriately to protect the data stored in memory of a legal cartridge against unauthorized access. Besides, there is a possibility to transfer identification code of the cartridge to the interface. Data in the form of musical compositions is, first of all, compressed using a password, then it is ciphered using code that is known to legal cartridge manufacturer and is recorded in this form to cartridge memory. The legal access to the above-mentioned data shall be performed via system that incorporates the auxiliary decoder of mobile karaoke transmitter and the key identification and coding device of the cartridge. They communicate via interface and provide for direct access to the data after successful check of the key codes that are pre-stored in the mentioned auxiliary decoder and the key-coding device of the cartridge.

Cartridge for mobile karaoke system may be equipped with a printed circuit board accommodating memory for storage of musical data that is made in the form of ROM chip, interface connector and key identification and coding device, which may be arranged in the form of microcontroller. This microcontroller shall be pre-programmed to provide for the possibility to protect the data that is stored in ROM and to transfer the cartridge identification code to the interface against its request with password from the transmitter that is linked to it. Cartridge may have a body that houses a printed circuit board.

Each cartridge may contain music of a certain style, for example, country or pop-music, it may be a collection of the best or specific songs performed by one or several singers.

Mobile transmitter for karaoke system may be assembled in a body with a socket (bed) that has an interface connector inside. Cartridge shall be inserted into this socket (bed) and the cartridge body shall be adapted for installation into such socket (bed). Communication interface of the transmitter and the cartridge may be in the form of contacts or it may be contact-free and communicate via optical electronic pairs, induction coupling, etc,

Mobile karaoke system for performance of musical compositions shall mix human voice and selected musical accompaniment, transmit the resulting signal to receiving device, including common home radio and amplifier system.

In this case, presented musical accompaniment and human voice may be processed using stereo effects.

The device shall provide for recording of many songs and there is a microcontroller that shall enable a performer to select songs, to control rhythm and tempo, sound effects and volume level from the point where the performer stays.

The device shall have no restrictions as regards location that may be caused by dimensions or power supply requirements, it can be easily carried by one person and it shall enable to playback sounds anywhere if a common radio set is available, such as home stereo radio or stereo radio with amplifier, or car stereo radio, or portable radio, or miniature radio "for walks".

The device shall provide for transmission of human voice and music accompaniment to a house, car, portable or miniature radio with power amplifier that supports the required level of sound mixing.

There are some specific features when ultrasonic acoustic channel is used for data transmission. As opposed to electromagnetic emission when the time of propagation from transmitter to receiver is negligible and can be ignored while assessing karaoke system operation, ultrasound propagation velocity is 340 m/sec. under usual conditions and that creates delay of received signal as compared to the transmitted one. This delay can be practically ignored when device is operated in small premises (volumes), for example in a passenger car, as well as in open space if receiver is located close to transmitter.

However, this signal delay should be taken into account for operation in medium-sized and large volumes (halls, bars, restaurants, etc.). Reverberation and echo effects may be produced due to propagation of direct and reflected ultrasonic signals. Unlike artificial reverberation and echo effects that are created by electronic circuits, the acoustic effects that are natural for ultrasonic channel are determined by dynamically changing room acoustics, by location and movements of both transmitters and receivers, as well as by availability and movements of other subjects that are interacting acoustically. It shall create the "presence effect", which is impossible to obtain artificially.

Another effect that is characteristic of ultrasonic communication channel is associated with absorption of ultrasonic emission, which depends considerably on frequency (it is approximately in proportion to the square of frequency value).

This feature so far was considered to be an obstacle for air communication via ultrasonic channel. However, as applied to mobile karaoke system, attenuation in ultrasound propagation in the air can be used as a positive feature. First of all, electromagnetic emission, which includes radio waves, infrared radiation, visible light and ultraviolet radiation, creates background "noise" from extraneous sources (interference, noise) at the reception point. In contrast to that, there is usually no ultrasonic emission around a human being due to attenuation. Therefore, even weak ultrasonic signals can be received reliably with high signal/noise ratio.

Radio waves drawback is that such a signal shall propagate for longer distances that are much longer than is required for mobile karaoke system. It shall also penetrate through walls of premises, which is not always desirable. User/performer may not wish to be heard by unauthorized persons. It can be also important for the work of professional performers and/or composers of music during creative search, rehearsals and preparation for release of new musical compositions.

When ultrasonic signal is used, it is possible to limit possible device operation area by selecting appropriate signal carrier frequency. So, such system shall have the same features regarding both mobility (wireless channel) and concealment or immunity to interception.

If carrier frequency of ultrasonic signal is 100KHz, the range of device operation shall be limited within 20-30 meters as, owing to absorption in the air, the signal attenuates by half when distance between transmitter and receiver is about 10 meters. In this case, ultrasound has practically no penetration to nearby rooms, because the difference in density between air and solid or liquid media (i.e. condensed media) is very high, so the boundary "air-liquid" or "air-solid" is practically impenetrable for ultrasound.

On the other hand, due to higher absorption of ultrasound, as compared to the range of human hearing, there is a possibility to adjust reverberation level by selecting frequency of ultrasonic signal.

If there is a need to provide public sound for bigger halls, squares, etc., miniature active repeaters/re-emitters may be used for high ultrasonic frequencies. They shall be arranged on the basis of the same principles as mentioned above regarding application of electric and/or magnetic near fields (antenna fields). In spite of attenuation of ultrasound in the air, it shall enable to establish transmission of high-frequency ultrasound to longer distances.

While a performer with a transmitter in hand is moving relative to receiver and within the room itself, signal characteristic that is specified by ultrasonic acoustics may change. It shall make the sound more natural as compared to singer's voice transmission from radio microphone in the form of radio signal or any other electromagnetic emission, which virtually ignores the natural acoustics of premises. Besides, it shall enable to get new adaptive, adjustable ultrasonic acoustic effects that are impossible or hard to be obtained within fixed range of hearing frequencies.

In fact, the invention pending shall provide for discrimination between the hearing sound frequency and the frequency of ultrasonic signal, which is actually the carrier of the hearing sound frequency. So, by selecting the method and modulation parameters for ultrasonic carrier it is possible to get the desired pattern of tone alteration while a performer and a listener are moving during presentation of musical composition.

Ultrasonic channel may be used both as the only (main) channel and as an auxiliary one for radio and/or optical channel. Practically any combinations of the above-mentioned channels can be implemented (optical, ultrasonic, near field transmission channel and radio channel).- It will be possible to obtain extra effects owing to different propagation velocity between electromagnetic and ultrasonic signals, which depends on the distance from transmitter to receiver.

Measuring of such difference value shall enable to get a signal, which describes distance between transmitter and receiver, and it can be used as control signal for additional adjustment of received signal parameters (tone, reverberation, echo, etc.).

Such joint application of two or more above-mentioned channels can mean the following.

First, in order to make the transmitter a universal device it would be practical if it is multichannel, as in different cases it would be desirable to use advantages of different channels. Receiving devices may also happen to be based on different channels. In this case, there will be a possibility of extra technical, artistic and emotional influence to listeners created by a performer. So, optical source that is used in optical communication channel may have adjustable directional pattern, and changing transmitter orientation may easily control the received signal. In this case, different channels can be used to control different parameters of received signals and it can be done with different effects for different listeners. It shall provide one more method of expression for a performer.

As regards frequencies of ultrasonic signal, when the signal is transmitted in the air under normal atmospheric pressure there will be the following estimated relationship between the distance of signal transmission (which is determined conventionally based on signal attenuation by 1000 times owing to absorption) and carrier frequency:

| Frequency | wavelength | distance |
|---|---|---|
| 1MHz | 3 µm | 10 m |
| 300KHz | 1 mm | 10 m |
| 100KHz | 3 mm | 100 m |
| 30KHz | 10 mm | 1000 m |

In this case, when ultrasonic channel is used as auxiliary for electromagnetic one, its bandwidth may be lower and that will also enable to decrease the carrier frequency of ultrasonic signal.

If sound synthesizer is placed to the receiver part and musical accompaniment data is transmitted in compressed, archived form, the bandwidth of ultrasonic channels may be reduced more considerably.

It shall be possible to receive feedback messages. The receiver part shall send an audio signal and such signal shall get acoustically to the transmitter, including the built-in microphone.

The signal that is sent by the transmitter is known (and it can be stored in cache memory) and the received signal can be distinguished from performer's input audio signal, therefore, there appears a possibility to find out the transformation that had been made to the signal as a result of its movement cycle: transmitter-receiver-transmitter. The receiver may be upgraded with integrated signal transducer and reflected signals can be processed (either amplified or attenuated). It can increase, in particular, the resolution power in signal identification as based on time of its reception.

The mobile transmitter may be rather small so that it can be easily carried in hand and transported. It can be used everywhere if a common FM radio is available, either in a car, at home or in the street. The device can be based on powerful amplifiers for houses or vehicles, bigger portable or miniature radios or amplifier systems for resulting sound with high output level. Even without cartridges the transmitter can provide a selection of up to 1,200 songs on the basis of its built-in ROM package.

Reception can be made through different FM radios, therefore, one performance may be listened through one or several radios or amplifier systems in a house or in other places so that many people with personal, mobile, portable, miniature or car radios will be able to listen to the performance. Besides, amplification of two or more systems may be combined.

Microcontroller inside the transmitter shall provide for performer the possibility to control completely the sound generated at the point of his location and to improve considerably the quality of performance.

Karaoke system is illustrated by the following drawings.
Fig.1 - block-diagram of standard karaoke system without visual display of performed words, which was known before;
Fig.2 - block-diagram of the present invention option, including the employed receiver;
Fig.3 - appearance of the device with its external controls that correspond to the present invention;
Fig.4 - block-diagram of device construction;
Fig.5 - diagram of Sound Playback Unit;
Fig.6 - circuit diagram of Frequency Modulator;
Fig.7 - algorithm of computer code for device control that is designated for microprocessor presented at Fig.4;
Fig.8 - circuit diagram for the second option of Frequency Modulator that is used in the device in compliance with the invention.

The same items and symbols, if not specified otherwise, in all the drawings are used to represent similar properties, elements, components or parts of the illustrated options. Besides, when the invention is described in detail with reference to the drawings, it is applied to the preferred option of implementation.

It means that various amendments and modifications of the described application prototype may be performed within the scope and concept of the invention as it is defined by the invention formula.

In the present invention memory for storage of musical accompaniment data, controller and microphone shall be combined into one mobile self-contained portable device.

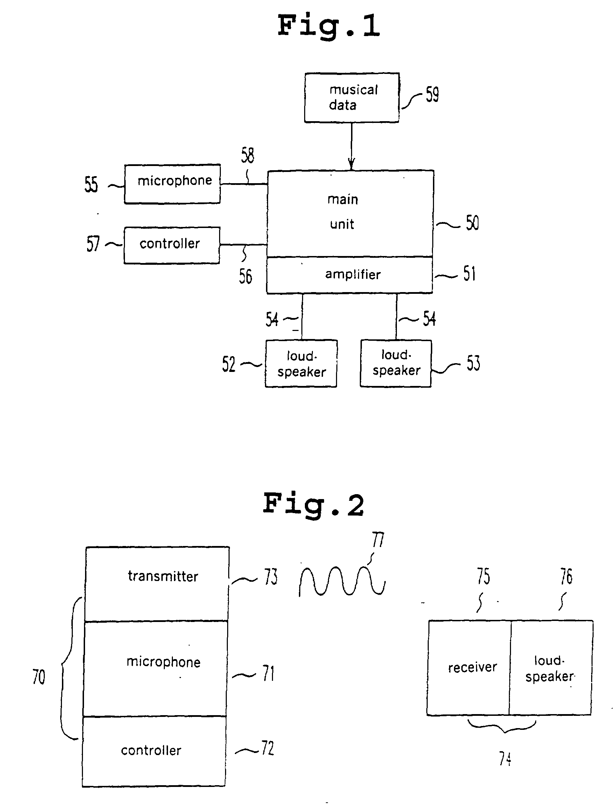

Fig.2 presents the diagram of karaoke system, which uses the device in compliance with the present invention. Device 70 contains Microphone 71, Controller 72 and Transmitter 73. The device shall use FM-radio 74, which includes Receiver 75 and Speaker 76 for generation of output audio signal on the basis of signal that has been formed by karaoke system 70. Signal 77 shall be a FM-signal, which is generated by Device 70 and transmitted to FM-radio 74. FM-radio 74 may be either a portable radio, or home or car stereo system, or any other appliance that can receive FM-signals and can play it back through one or several speakers.

Most of standard receivers incorporate powerful amplifier. It is preferential to use frequency modulation, but it is also possible to transmit and receive signals of other modulation forms, not necessarily within FM band. System architecture as presented at Fig.2 provides for easy transportation of karaoke system 70, it shall not require many wire connections and shall have no restrictions in terms of power supply.

FM-receiver 74 may be small-sized like a portable radio, for example, and karaoke system 70 shall not be limited to use of only one receiver. So, there is a possibility to carry Device 70 from vehicle to vehicle or from house to house and it can be used everywhere, if FM-radio is available.

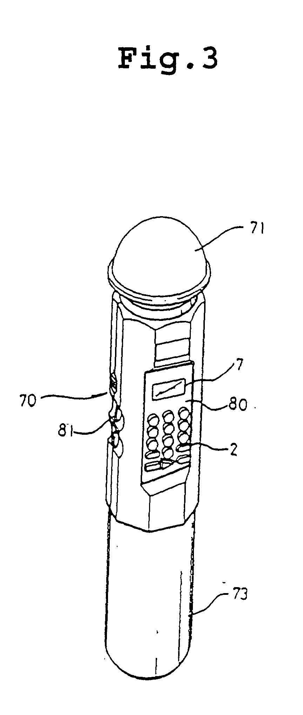

Fig.3 presents the appearance of karaoke system 70 with some of its controls. One can see Microphone 71, Control Panel 80 that includes Key Matrix 2, Display Panel 7 and auxiliary switches 81. Transmitter 73 is built-in the base of karaoke device 70.

Control Panel 80 and auxiliary switches 81 shall be used for selection of accompaniment and for modification of signal acoustic parameters as described below.

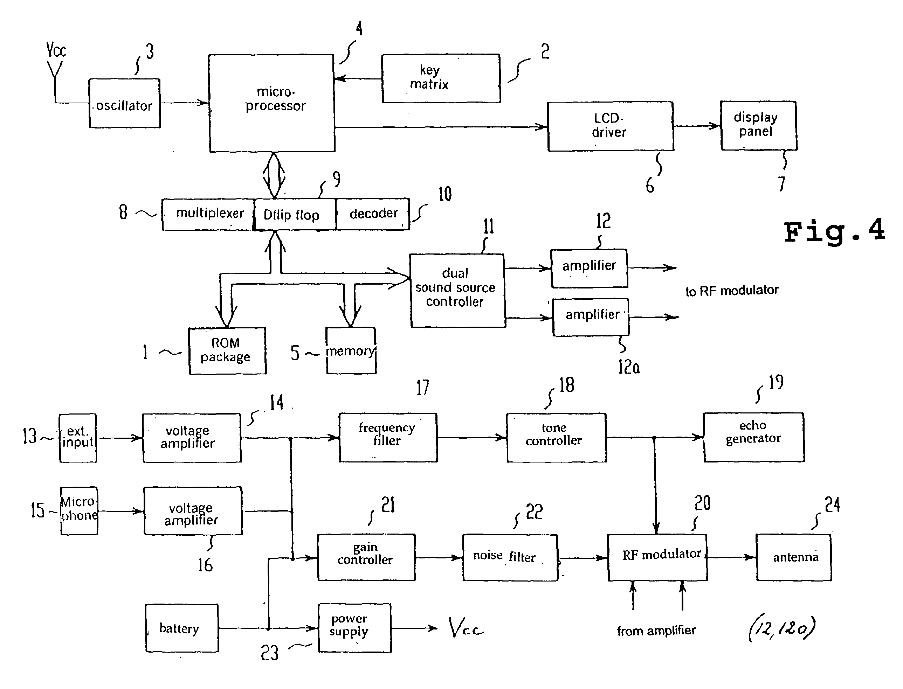

According to Fig.4, device 70 includes two major parts - sound accompaniment playback unit and frequency modulator.

Sound playback unit incorporates ROM Package 1, Key Matrix 2, Microprocessor 4, Memory 5, Display Panel 7, Multiplexer 8, Dual Sound Source Controller 11 and Amplifiers 12 and 12a.

Various melodies of musical accompaniment with respective numeration shall be stored in ROM Package 1 in the form of digital signals.

Design of memory array shall provide for whatever extension as required.

Input signals from Key Matrix 2, which constitute numbers of songs selected by user, as well as high frequency sync pulses from Oscillator 3 with crystal control are transferred to Microprocessor 4 that performs the entire system control in compliance with program pre-stored in its internal memory. The program finds musical data corresponding to the selected number and sends it to Memory 5, which is static storage with random access. Microprocessor 4 also controls the retrieval of musical data from ROM Package 1 via Multiplexer 8,

D Flip Flop 9 and Decoder 10.

Besides, Microprocessor 4 presents the information about system functional status to Display Panel 7 via LCD Driver 6. It also provides for transmission of musical accompaniment signals to Dual Sound Source Controller 11 for their further amplification by Amplifiers 12 and 12a. Frequency modulator unit of device 70 (it corresponds to Microphone 71 at Fig.3) includes Voltage amplifiers 14 and 16, Frequency Filter 17, Tone Controller 18, Echo Generator 19, Radio Frequency (RF) Modulator 20, Gain Controller 21, Noise Filter 22, Power Supply 23 and Antenna 24.

Audio signal from Ext. Input 13, which can comprise an external microphone, or from internal MIC 15 is delivered to Amplifiers 14 and 16 respectively. Then the amplified audio signal is processed by Frequency Filter 17 in order to get the required signal form and by Tone Controller 18 in order to select either high or low tone. Audio signal after the Tone Controller is mixed with echo-signal that is delivered from Echo Generator 19 and the mixed signal is sent to RF Modulator 20 where it is converted into radio signal. This radio signal is a standard frequency-modulated signal. Gain Controller 21 also adjusts the above-mentioned audio signal to improve its differential gain and differential phase with further increase of signal/noise ratio via Filter 22 and with reduction of noise, which is present in the signal. Low-noise signal is then delivered to Modulator 20 to be combined with verbal audio signal.

Adjustable input audio signals and playback signal of musical accompaniment from Amplifiers 12 and 12a are delivered simultaneously to RF Modulator 20, and frequency-modulated signal that carries human voice and musical accompaniment is transmitted to standard FM-radios via Antenna 24.

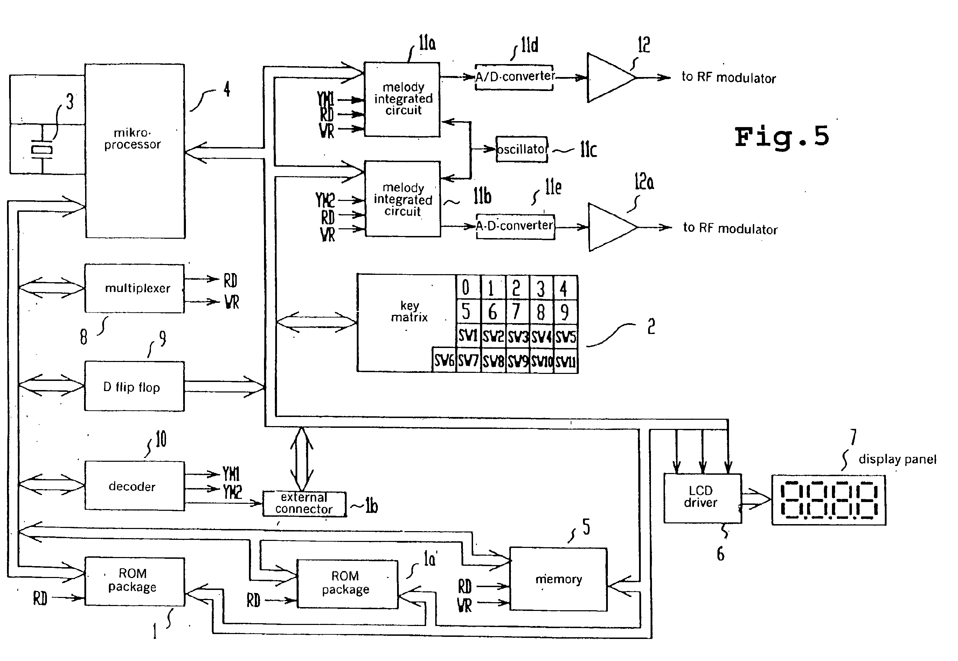

Fig.5 presents a detailed diagram of musical accompaniment playback in compliance with Fig.4. ROM Package 1 designated for storage of digital signals of musical accompaniment and their respective numbers has auxiliary ROM Package 1a, which is linked to external connector 1b, and it helps to upgrade such memory arrays. Further to the internal memory, use of external plug-in memory blocks shall enable to get access to maximum possible number of musical accompaniments.

Key Matrix 2 has keys numbering from 0 through 9 for selection of desired number of melody, keys SW1 for rhythm and tempo adjustment, control SW2 for modification of musical tone, control SW3 to set the tempo and SW4 for setting the musical tone to the required value during melody playback when the respective keys SW1 and SW2 are switched on.

Key Matrix 2 also includes a reset key SW5 that is used to return the system to normal or initial status in case there are any difficulties in operation or if any mistakes have been made in selection of keys. Key of continuos operation SW6 is used for sequential playback of musical accompaniment that is stored in ROM Package without additional selection of song number. Key SW7 is designated for selection of any external ROM Packages when they are plugged-in the external connector 1b. Key SW8 creates echo-effects for voice signal from the microphone; start key SW9 turns on the selected musical accompaniment; stop key SW20 terminates melody playback to change song number; and On/Off key SW11 supplies power from Power Supply 23, which is supported by built-in battery, for example.

Input signals from Key Matrix 2 and sync pulses from Oscillator 3 with crystal control are delivered to Microprocessor 4, which controls the entire system in compliance with the program below. Microprocessor 4 saves in Memory 5 the data that corresponds to selected accompaniment. At the same time Microprocessor 4 sends an output signal in the form of data that is transmitted serially, a clock signal and a loading signal for LCD display to LCD Driver 6 via internal data bus and it generates the code of functional status for seven indicators of Display Panel 7.

When Microprocessor 4 selects specific data, musical accompaniment for example, from the data pre-stored in ROM 1 or ROM 1a via internal bus, the selected data is written or read from Memory 5 via Multiplexer 8 and Decoder 10, while the output data is read via D Flip Flop 9. Output signals, such as signal of chip selection YM1, YM2 from Decoder 10, and signals of reading and writing RD3, WR4 from Multiplexer 8 are delivered to Dual Sound Source Controller 11 via internal data bus. Dual Sound Source Controller 11 comprises two Melody Integrated Circuits (IC) 11a and 11b, Oscillator 11c and two digital-analogue (D/A) converters 11d and 11e. In response to the input signal Melody IC 11a and 11b generate rhythm stereo signals on the basis of musical data retrieved from ROM Package 1 or 1a. Respective D/A converter converts output signals from Melody IC 11a and 11b in order to receive analogue signal, which corresponds to the original musical accompaniment. Amplifier 12, 12a amplifies output signals from each D/A converter 11d and 11e, as it is required for RF modulator 20.

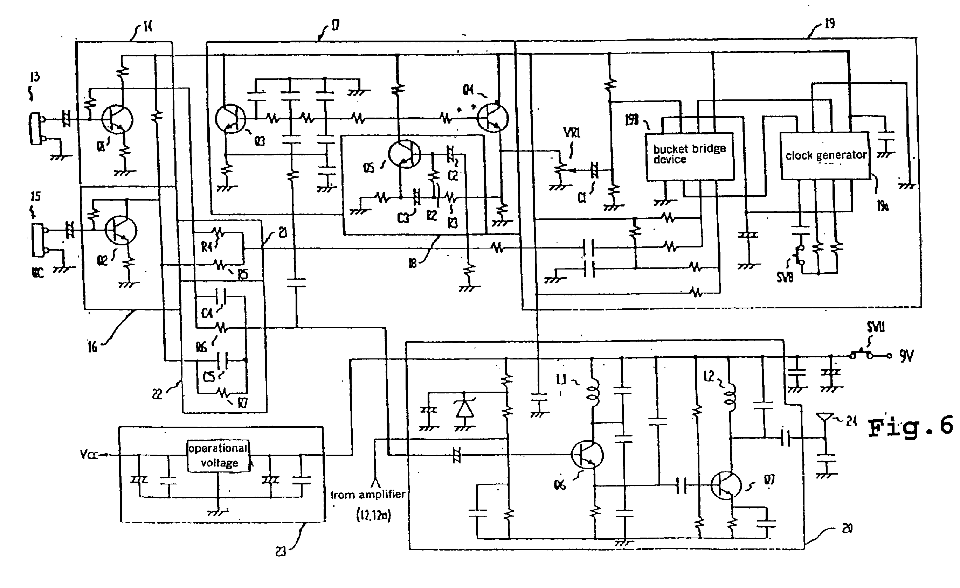

Fig.6 presents detailed circuit diagram for the frequency modulator unit in Device 70. Audio signals from external input 13, which is linked to external microphone, or from built-in Microphone 15 are delivered to Voltage amplifiers 14, 16 based on transistors Q1, Q2 respectively in order to get the required signal level. Every amplified input signal is filtered by transistors Q3, Q4 of Frequency Filter 17 and obtains the required shape via Controller 18 based on transistor Q5, resistors R2, R3 and capacitors C2, C3.

Input audio signal that has been shaped selectively by its high or low tone level is delivered to RF Modulator 20, which also receives output signal from Echo Generator 19. Echo Generator 19 is implemented in a standard form and includes Clock Generator 19a and Bucket Bridge Device 19b. In order to produce echo sound the echo generator delays the input signal of low level by a time constant, which is determined by variable resistor VR1, capacitor C1 and resistor R1.

Echo sound is produced only if key SW8 is depressed at Key Matrix 2.

In order to improve the parameters of differential gain and phase, the amplified input audio signal from Voltage Amplifiers 14 and 16 is adjusted by Gain Controller 21, which includes a divider based on resistors R4 and R5. Signal/noise ratio is increased by eliminating noise component in Noise Filter 22, which is based on resistors and capacitors R6, C4 and R7, C5, as presented at Fig.6. The processed audio signal is mixed with echo-signal, which is produced by Echo Generator 19. The adjusted input audio signal and playback musical signal from Amplifiers 12 and 12a are delivered simultaneously to RF Modulator 20 where the input audio signal is transformed into a radio-frequency signal that is modulated at modulation frequency via inductance coil L1 and transistor Q6. Then the radio signal is fine-tuned in RF Modulator 20 by coil L2 and transistor Q7. Finally, the output frequency-modulated signal that carries singer's voice and musical accompaniment can be transmitted to Antenna 24 and may be received by FM-radio, which is tuned to the output frequency of the device.

In the given device the power voltage from built-in battery (9V, for example) is supplied directly to sound amplifier and to RF modulator. The operational voltage (Vcc) 5V is supplied to other units via Voltage Regulator chip in Power Supply 23 if power switch SW11 at Key Matrix 2 is ON.

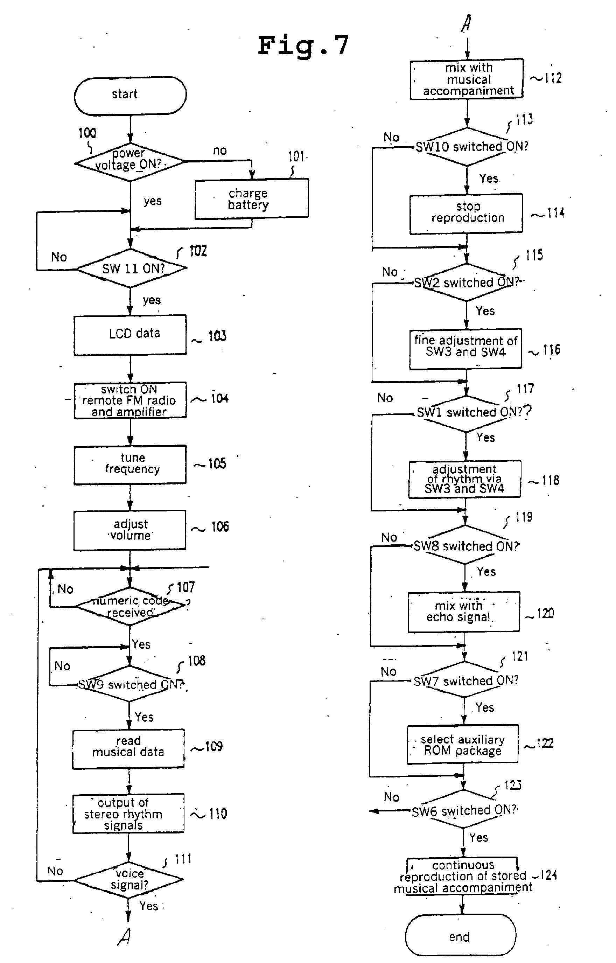

Block-diagram at Fig.7 presents the operation algorithm for Microprocessor 4 (see Fig.4) to perform control functions in compliance with the present invention. At phase 100 it is determined whether power voltage 9V is ON. If the required voltage is not available, battery is either charged or replaced at phase 101. If power switch SW1 is defined as ON at phase 102, then at phase 103 Microprocessor 4 generates signal LCD DATA (data to LCD display), clock signal LCD CLK, loading signal LCD LDP, then it sends them to LCD driver 6 and displays "1" at Display panel 7. It corresponds to normal power voltage Vcc that is supplied from Power Supply 23.

Extra operations need to be performed in order to use microphone and signal regulator. To do this would require switching ON power of remote FM-radio and amplifiers at phase 104, tuning in the pre-determined frequency at phase 105 (for example, 98.1+1MHz or 100+1MHz) and adjusting the required volume at phase 106. When numeric code, which corresponds to desired song number, is received from Key Matrix 2 at phase 107, Multiplexer 8 selects one of ROM Packages 1 or 1a (in compliance with position of switch SW7) and respective pre-stored data is retrieved via data bus. Phase 108 defines whether switch SW9 is ON and if it is ON, the pre-stored musical data is read at phase 109 via D Flip Flop 9.

Digital data, which is read from ROM Package 1 or 1a, is delivered to Melody IC 11a, 11b of Dual Sound Source Controller 11 via Multiplexer 8. Melody IC 11a, 11b shape rhythm stereo signals on the basis of output signal from Oscillator 11c. These signals are transferred to respective D/A converters where they are transformed into analogue signals. The analogue output signals are transmitted to Amplifiers 12a, 12b and the amplified analogue signals of musical accompaniment at phase 110 are delivered to RF modulator 20 where they are transformed into FM-signals. And then they are transferred to Antenna 24.

The following phase 111 defines whether audio signal is available at the voice input from either external or built-in microphone. If the user wants to playback some musical accompaniment, the input audio signal is mixed with musical signal at phase 112.

If at phase 113 the stop key SW10 at Key Matrix 2 is depressed during the above procedure, then playback of selected musical accompaniment is terminated at phase 114. If at phase 115 it is needed to change musical tone of accompaniment and the control SW2 is ON, tone may be adjusted to the required value during music playback. Controls SW3 and SW4 are adjusted at phase 116 (up or down) in order to choose the required level.

If the rhythm control SW1 is activated at phase 117, then it is possible at phase 118 to accelerate or slow down the rhythm by pressing the respective keys as many times as required. In compliance with the above operations of tone and rhythm adjustment, Microprocessor 4 presents the settings numeric values at Display panel 7.

If it is defined at phase 119 that the echo-effect key SW8 is ON, then audio echo-signal from Echo Generator 19 is delivered to RF Modulator 20 and it is mixed with demodulated signal at phase 120. If it is detected at phase 121 that the ROM package selection key SW7 is depressed and if auxiliary ROM package 1a is plugged in, then the respective ROM package is selected via Multiplexer 8 at phase 122 and the desired musical accompaniment is selected. Each ROM package may contain music of certain style; there are many options for ROM package contents.

If at phase 123 the key SW6 for sequential playback is depressed, then the following playback of musical accompaniment, which is pre-stored in ROM package 1 or 1a, is performed at phase 124 and the song number does not need to be selected. According to the present invention, device 70 may process on a selective basis input audio signals that contain voice and playback musical accompaniment to produce a mixed signal and to transmit it via FM-channel in the form of stereo-signal. Such design of self-contained karaoke device, which is commonly used with standard FM-radio, makes it possible to be operated indoors, outdoors or in a vehicle, any place where FM-radio is available. User can also sing to music accompaniment while walking in the street and use a compact radio for reception of transmitted signals.

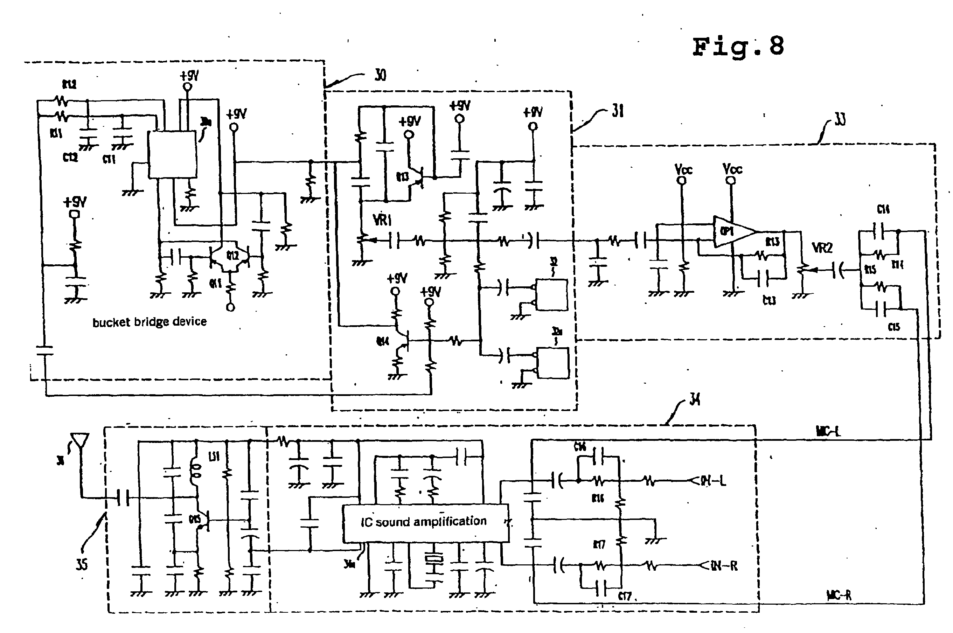

Fig.8 presents the second example of implementation of frequency modulator, which was seen at Fig.6. Frequency modulator unit at Fig.8 includes Echo Generator 30, Tone Controller 31, Gain Controller 33, Noise Filter 34, RF Modulator 35 and Antenna 36. Echo Generator 30 comprises Bucket Bridge Device 30a that is linked to resistors R11, R12 and capacitors C11, C12 for. generation of echo-signal, which is delayed by a time constant as defined by R11, R12, C11, C12 values, and for, amplification of audio echo-signal via a push-pull circuit as based on transistors Q11 and Q12.

Output echo-signal is delivered to Tone Controller 31 to control the gain factor of transistor Q13 via adjustment of resistor VR11 and to be mixed with the voice sound that is transferred from input terminals 32 and 32a of stereo microphone. The output audio echo-signal is also adjusted by transistor Q14 as relative to the level of input voice signal.

Input audio signal is mixed with echo-sound, if required, and is delivered to Gain Controller 33 that includes an operation amplifier OP1, which has a feedback loop based on resistor R13 and capacitor C13, a variable resistor VR2 that adjusts amplitude, and a filter comprising resistors R14, R15 and capacitors C14, C15. The gained input signal, which has been processed by operation amplifier OP1, supports output signal of required level via adjustment by variable resistor VR2. Then the input audio signal is divided by filter into stereo audio signals MIC-L and MIC-R.

Stereo audio signals are mixed with playback signals of musical accompaniment IN-L and IN-R, respectively, which pass through noise filter consisting of resistors R16, R17 and capacitors C16, C17. The mixed signal is amplified in Audio Amplifier IC 34a, transformed by RF Modulator 35 and fine-tuned to the frequency that is generated by generator comprising of inductance coil L11 and transistor Q15.

Thus, the modulated output signal, which carries human voice sound and musical accompaniment, can be transmitted via Antenna 36 and received by standard FM-radio within the range of radio reception. Voltage power from the internal source (9V Battery here) is supplied directly to Audio Amplifier and Frequency Modulator, and via voltage regulator (not shown) in the Power Supply the operational voltage 5V (Vcc) is supplied to other circuits if the power switch SW11 is ON at Key Matrix 2.

The above description explains the principles of the invention. Experts in this type of equipment may create various systems and devices, which can differ from the above mentioned, but may implement the principles of the invention and, therefore, they shall be within the scope and concept of this invention.

If equivalent integrated circuits are used for implementation of each functional unit, system dimensions will be reduced considerably and its level of mobility will be raised.

Mobile karaoke system uses auxiliary decoder for communication with cartridge via interface connector and cartridge uses key identification and coding device that is linked to ROM package. These features shall prevent the possibility of unauthorized access to the data that is stored in Read-Only-Memory, besides, the karaoke system shall not operate with unauthorized illegal cartridge.

### References

1. US, A, 5654516, G 10 H 7/00, 05.08.97. Karaoke system having a playback source with pre-stored data and a music synthesizing source with rewriteable data.
2. WO, A1, 94/27282, G 10 h 1/36, 24.11.94. Portable music performance device.
3. US, A, 4813014, G 11 C 27/00, 14.03.89. Digital audio memory system.
4. GB, A, 2249889, G 11 C 27/00, 20.05.92. Digital sound source device and external memory cartridge used therefor.

### Invention Formula

1. Mobile karaoke system that shall incorporate the following components:
   - mobile wireless transmitter,
   - collection of authorized legal cartridges with pre-stored musical accompaniment,
   - mobile device for receiving of signals from the transmitter,
   - mobile device for conversion of received signals into acoustic sound,

   In this case, the mobile wireless transmitter shall have the body that can be held, moved and controlled conveniently by performer. Inside this body or on top of it there are the following components: microphone for input of acoustic signal, control panel for selection of desired melody by a performer, microprocessor, synthesizer that is integrated with the microprocessor and that is programmed so that to provide adjustment of tone, rhythm and tempo, sound delay, echo level and artificial reverberation as well as volume of performance, scanning device for searching of music accompaniment with decoder, memory that contains data of musical accompaniment for a limited number of songs and that is linked to interface connector via multiplexer for plugging-in one of many cartridges. It shall be made in the form of a bed or a socket that provides for convenient input and fixing of cartridge being plugged into interface connector. Further to the above mentioned, the body shall contain a device for conversion and processing of singer's voice, for getting the first signal and playback musical signal as the second signal; device for generation of resulting output electric signal as the third signal that is produced by mixing the first and the second signals and for its further transmission in the form of modulated emission into surrounding space, which can be received by a mobile device for receiving of transmitted signals; auxiliary decoder for communication with the cartridge via interface connector, which enables to recognize authorized legal cartridge that is protected against unauthorized access by authorized key code device with access password. It shall prevent operation of mobile wireless transmitter with unauthorized and/or illegal cartridge or any other information storage media that has no authorized key coding device with such access password;
   in this case, each cartridge that is included into the mentioned collection shall contain Read-Only-Memory chips, which are linked to each other and to interface connector. The chips are used for storage of coded data of musical accompaniment. Besides, there are chips of authorized key identification and coding device with access password that are used to prevent unauthorized access to the data that is stored in Read-Only-Memory of the cartridge and to identify that the cartridge belongs to the above mentioned collection.
2. Mobile karaoke system similar to item 1, but differing in that its mobile wireless transmitter can transmit modulated optical signal, and its mobile receiving device shall be arranged in the form of "n" optical receivers, where "n" is a whole number not less than 1.
3. Mobile karaoke system similar to item 1, but differing in that its mobile wireless transmitter can transmit modulated acoustic ultrasonic signal, and its mobile receiving device shall be arranged in the form of "n" ultrasonic receivers, where "n" is a whole number not less than 1.
4. Mobile karaoke system similar to item 1, but differing in that its mobile wireless transmitter can transmit modulated radio signal in the first frequency band, which is specially selected to provide for electromagnetic compatibility with other active radio sources as well as with devices that are sensitive to radio emission, and its mobile receiving device shall be arranged in the form of "n" converters/repeaters (where "n" is a whole number not less than 1) for further transmission of received signal in the second band to "n" radios.
5. Mobile karaoke system similar to item 4, but differing in that its first frequency band shall fall into the range of 26-30MHz and the second band shall fall into the range of 67-108MHz.
6. Mobile karaoke system similar to items 4 or 5, but. differing in that its transmitter can transmit radio signal on the carrier frequency f₀ that falls into the first band, and the receiver incorporates "n" individual converters/repeaters where "n" is a whole number not less than 1. The converter/repeater "i" ("i" is 1,2...n) can receive signals on the carrier frequency f₀ and can perform its further transmission in the form of frequency-modulated radio signal on the carrier frequency fᵢ that falls into the second band. The converters/repeaters shall be located in "n" areas of consistent reception of transmitter signals, and the device used to convert the received radio signal into acoustic signal shall be arranged in the form of "n" home radios that can receive radio waves in the second band. In this case, radio set "i" (where "i" is 1,2..., n) shall be tuned to received radio carrier frequency fᵢ that is radiated by converter/repeater "i" and this radio set shall be close to it.
7. Mobile karaoke system similar to item 1, but differing in that its mobile wireless transmitter can transmit modulated electromagnetic signal of near field, and its mobile receiver shall be arranged in the form of "n" electromagnetic converters of near field (where "n" is a whole number not less than 1) that are linked to "n" respective acoustical-electrical transducers/amplifiers.
8. Mobile karaoke system similar to any of items 4 through 7, but differing in that its transmitter is upgraded with an additional device for locking the transmission of signals in the second frequency band.
9. Method to provide electromagnetic compatibility for mobile karaoke system. This method includes the following steps. Musical data from memory with interchangeable cartridge is selected and decoded for obtaining of the first signal. Acoustic signal is received and converted via a microphone for obtaining of the second signal, and the first and second signals are processed. The resulting output electric signal is shaped and a radio signal is generated and transmitted at the carrier frequency f₀ that falls into the first band, which is allocated for free usage subject to limited radiation power. The radio signal is modulated by the above-mentioned resulting electric signal with given limited radiation power P₁. This radio signal is received in various "n" areas by "n" transceivers of the first type and it is transformed and re-radiated by each of the above-mentioned transceivers of the first type at frequency fᵢ that falls into the second band. The power of radiation here shall be not higher than kP₁ where k<0,1. The repeated signal is received independently in each area "i" ("i" = 1,2,..., n) at the carrier frequency fᵢ by radio receiver "i" of the second type. And, finally, the radio signal is converted into acoustic sound.
10. Method similar to item 9, but differing in that the first band shall fall to the range of 26-30MHz and the second band shall fall to the range of 67-108MHz.
11. Method similar to any of items 9,10, but differing in that the radio receiver of the second type shall be replaced with a standard broadcast radio with radio frequency band that includes at least one of the following ranges: either 67-88MHz or 88-108MHz.
12. Method similar to any of items 9,10,11, but differing in that distance Lᵢ between the above-mentioned devices of the first and second type in each area shall not exceed the maximum length of any of their antennas.
13. Method similar to any of items 9 through 12, but differing in that the transmission of signals from every device "i" of the first type to its respective device "i" of the second type shall be effected via electric and/or magnetic near field.
14. Method similar to item 13, but differing in that here the devices of the first type shall provide for suppressing of radio transmission of far field.
15. Mobile wireless transmitter for mobile karaoke system with a body that can be held, moved and controlled conveniently by a performer. Inside the body or on top of it there are the following components: microphone for input of acoustic signal, control panel, microprocessor, synthesizer that is integrated with the microprocessor, scanning device for searching of music accompaniment with decoder, memory that is linked to interface connector via multiplexer for plugging-in one of many cartridges. It shall be made in the. form of a bed or a socket that provides for convenient input and fixing of cartridge being plugged into interface connector. Further to the above mentioned, the body shall contain a device for conversion and processing of the microphone signal and the playback musical signal; device for generation of final output electric signal and for its further transmission in the form of modulated emission into surrounding space; auxiliary decoder for communication with the cartridge via interface connector, which enables to recognize authorized legal cartridge that is protected against unauthorized access by authorized key code device with access password. It shall prevent operation of mobile wireless transmitter with unauthorized and/or illegal cartridge or any other information storage media that has no authorized key coding device with such access password.
16. Mobile wireless transmitter for mobile karaoke system similar to item 15, but differing in that the transmission of signal from it to the environment shall be effected in the form of electromagnetic radiation within optical band.
17. Mobile wireless transmitter for mobile karaoke system similar to item 15, but differing in that the transmission of signal from it to the environment shall be effected in the form of ultrasonic radiation.
18. Mobile wireless transmitter for mobile karaoke system similar to item 15, but differing in that the transmission of signal from it to the environment shall be effected in the form of radio waves within vacant allocated frequency band that is not used by broadcast and service communication transmitters.
19. Cartridge for mobile karaoke system that includes the following components: body that can be inserted into the bed of mobile karaoke transmitter and interface connector for plugging into the interface of mobile karaoke transmitter. Besides, there is Read-Only-Memory package for storage of data in the form of musical compositions and key identification and coding device in the form of microcontroller that is appropriately programmed. This device is linked to ROM package and it can communicate with auxiliary decoder of the mobile karaoke transmitter via interface connector to prevent unauthorized access to the data stored in ROM package and to provide for automatic cartridge identification through the mechanisms existing in mobile karaoke transmitter used to prevent input of data from any cartridge or data storage media that is not included in the collection of authorized legal cartridges. Chips of the above mentioned devices shall be mounted to printed circuit board that is installed inside the cartridge body.
20. Cartridge similar to item 19, but differing in that its key coding device shall be implemented in the form of protected data base with a password. It shall activate data exchange with mobile karaoke transmitter that is linked to it only if its auxiliary decoder contains a password, which is identical to the above-mentioned one.
21. Method that prevents the use of unauthorized (illegal, pirate) cartridges and other data storage media in mobile karaoke system with legal mobile karaoke transmitter. In compliance with this method, karaoke transmitter shall be upgraded with a device for cartridge identification as the one that is included into the authorized collection of legal cartridges. Besides, the transmitter shall be equipped with a device that locks reception of data from the interface if it is detected that this interface is linked to unauthorized data storage media. And all cartridges that are included into the collection of authorized cartridges shall be supplied with key coding and identification device with access password.
22. Method to prevent unauthorized access, copying and use of data stored in the memory of any authorized legal cartridge for mobile karaoke system. In compliance with this method, mobile karaoke transmitter shall be upgraded with auxiliary decoder, and each authorized legal cartridge shall be equipped with data protection capability. It is realized as a key identification and coding device that incorporates a microcontroller, which is programmed accordingly to protect the data stored in memory of legal cartridge against unauthorized access. Besides, there is a possibility to transfer identification code of the cartridge to the interface. Data in the form of musical compositions is, first of all, compressed using a password, then it is ciphered using a code that is known to legal cartridge manufacturer and, finally, it is recorded in this form to cartridge memory. The legal access to the above-mentioned data shall be performed via system that incorporates the auxiliary decoder of mobile karaoke transmitter and the key identification and coding device of the cartridge. They communicate via interface and provide for direct access to the data after performance of successful check of key codes that are pre-stored in the mentioned auxiliary decoder and the key-coding device of the cartridge.

## Claims

1. Mobile karaoke system comprising:
- a mobile wireless transmitter,
- a plurality of cartridges with music accompaniment stored thereon,
- a mobile receiving device for receiving signals from said mobile wireless transmitter and
- a mobile conversion device for conversion of said received signals into acoustic signals,
wherein said mobile wireless transmitter has a body that can be held, moved and controlled conveniently by a performer and in particular comprises:
a microphone for input of acoustic signals, a control panel, a microprocessor, a sound synthesizer, a scanning device for searching of music accompaniment having a decoder, a memory linked to an interface connector via a multiplexer for plugging-in one of said cartridges, a socket for convenient input and fixing of said cartridge being adapted to be plugged to said interface connector, a device for convertion and processing of a singer's voice in order to provide a first signal and a playback musical signal as a second signal, a device for generation of a resulting electric output signal as a third signal and for transmission of said output signal as modulated emission into surrounding space, an auxiliary decoder for communication with said cartridge via interface connector adapted to recognize an authorized cartridge, wherein said cartridge is protected against unauthorized access by a key coding device having an access password to prevent operation of said mobile wireless transmitter if an unauthorized or illegal cartridge or any other information storage media without said key coding device having said access password is used,
and wherein each of said cartridges has Read-Only-Memory chips which are linked to each other and to said interface connector, said chips being used for storing coded music data of said music accompaniment, said chips for authorized key identification and coding device having an access password being used to prevent unauthorized access to the data stored in said Read-Only-Memory of said cartridge and serving to identify said cartridge.

2. Mobile karaoke system as claimed in claim 1, **characterized in that** said mobile wireless transmitter is adapted to transmit modulated optical signals and said mobile receiving device is arranged in the form of "n" optical receivers where "n" is a whole number not less than 1.

3. Mobile karaoke system as claimed in claim 1, **characterized in that** said mobile wireless transmitter is adapted to transmit modulated acoustic ultrasonic signals and said mobile receiving device is arranged in the form of "n" ultrasonic receivers, where "n" is a whole number not less than 1.

4. Mobile karaoke system as claimed in claim 1, **characterized in that** said mobile wireless transmitter is adapted to transmit modulated radio signals in a first frequency band, which is specially selected to provide for electromagnetic compatibility with other active radio sources as well as with devices that are sensitive to radio emission, and said mobile receiving device is arranged in the form of "n" converters/repeaters (where "n" is a whole number not less than 1) for further transmission of received signals in a second frequency band to "n" radios.

5. Mobile karaoke system as claimed in. claim 4, **characterized in that** said first frequency band is in the frequency range of 26-30 MHz and said second frequency band in the range of 67-108 MHz.

6. Mobile karaoke system as claimed in claim 4 or 5, **characterized in that** said mobile wireless transmitter is adapted to transmit radio signals on a carrier frequency fₒ which falls into said first band and said said receiving device has "n" individual converters/repeaters (where "n" is a whole number not less than 1), each converter/repeater "i" ("i" being 1, 2..., n) being adapted to receive signals on said carrier frequency fₒ and to perform theirs further transmission in the form of frequency-modulated radio signals on a carrier frequency fᵢ falling into said second frequency band, said converters/repeaters being located in "n" areas of consistent reception of transmitter signals, wherein the device used to convert the received radio signals into acoustic signals is arranged in the form of "n" home radios adapted to receive radio waves in said second frequency band, wherein each radio set "i" (where "i" is 1, 2..., n) is adapted to be tuned to receive the radio carrier frequency fᵢ which is radiated by the converter/repeater "i".

7. Mobile karaoke system according to claim 1, **characterized in that** said mobile wireless transmitter is adapted to transmit modulated electromagnetic signals of near field and said mobile receiving device is arranged in the form of "n" electromagnetic converters of near field (where "n" is a whole number not less than 1) which are linked to "n" respective acoustical-electrical transducers/amplifiers.

8. Mobile karaoke system according to any of claims 4 to 7, **characterized in that** said mobile wireless transmitter is provided with a device for blocking the transmission of signals in said second frequency band.

9. Method for providing electro-magnetic compatibility for a mobile karaoke system having the following steps:
selecting and decoding musical data from a memory of an interchangeable cartridge for obtaining a first signal, receiving and converting an acoustic signal via a microphone for obtaining a second signal, processing said first and second signals, forming a resulting electric output signal, generating and transmitting a radio signal at a carrier frequency fₒ being within a first frequency band available for free usage subject to limited radiation power, wherein the maximum radiation power allowed to be used in this first frequency band is P₁, receiving this radio signal in various "n" areas by "n" transceivers of a first type, transforming and re-radiating this radio signal by each of said transceivers of said first type at a frequency fᵢ which falls into a second frequency band, wherein the power of radiation in said second frequency band is not higher than k*P₁, wherein k<0,1, receiving said signals in each area "i" ("i" = 1, 2,..., n) at the carrier frequency fᵢ by a radio receiver "i" of a second type and converting it into acoustic sound.

10. Method according to claim 9, **characterized in that** said first frequency band falls in the range of 26-20 MHz and said second frequency band falls in the range of 67-108 MHz.

11. Method according to claims 9 or 10 **characterized in that** said receivers of said second type are standard broadcast radios having a radio frequency band which includes at least one of the following ranges: either 67-88 MHz or 88-108 MHz.

12. Method according to claims 9, 10 or 11, **characterized in that** the distance Lᵢ between said devices of said first and second type in each area does not exceed the maximum length of their antennas.

13. Method according to any of claims 9 to 12, **characterized in that** the transmission of signals from a device "i" of the first type to the respective device "i" of the second type is effected via electric and/or magnetic near field.

14. Method according to claim 13, **characterized in that** said devices of said first type provide for suppressing of radio transmission of the far field.

15. Mobile wireless transmitter for a karaoke system having a body which can be conveniently held, moved and controlled by a performer, wherein there are provided inside the body or on top thereof the following components:
a microphone for input of acoustic signals, a control panel, a microprocessor, a synthesizer coupled with said microprocessor, a scanning device for searching of music accompaniment having a decoder, a memory linked to an interface connector via a multiplexer for plugging-in one of said cartridges, a socket for convenient input and fixing of said cartridges, a device for conversion and processing of a microphone signal and a playback musical signal, a device for generating a final output electrical signal and for the transmission thereof in the form of modulated emission into surrounding space, an auxiliary decoder for communication with said cartridge via interface connector which is adapted to recognize an authorized cartridge being protected against unauthorized access by an authorization key coding device having an access password to prevent operation of said mobile wireless transmitter with an unauthorized cartridge or any further information storage media without said authorization key coding device having such access password.

16. Mobile wireless transmitter according to claim 15, **characterized in that** it is adapted to transmit signals in the form of electromagnetic radiation within the optical frequency band.

17. Mobile wireless transmitter according to claim 15, **characterized in that** it is adapted to transmit signals in the form of ultrasonic radiation.

18. Mobile wireless transmitter according to claim 15, **characterized in that** it is adapted to transmit signals in the form of radio waves within a vacant allocated frequency band which is not used by broadcast and service communication transmitters.

19. Cartridge for a mobile karaoke system comprising the following components:
a body which can be inserted into a plug-in device of a mobile karaoke transmitter, an interface connector for plugging into the interface of said mobile karaoke transmitter, a Read-Only-Memory package for storing data in the form of musical compositions, a key identification and coding device in the form of a programmed microcontroller, said key coding device being linked to said Read-Only-Memory package and adapted to communicate with an auxiliary decoder of said mobile karaoke transmitter via said interface connector to prevent unauthorized access to data stored in said Read-Only-Memory package and to provide for automatic cartridge identification to prevent operation of an unauthorized cartridge or data storage media.

20. Cartridge according to claim 19, **characterized in that** said key coding device has a data base having a password, wherein data exchange with said mobile karaoke transmitter is activated only if its auxiliary decoder contains an identical password.

21. Method for preventing the use of an unauthorized cartridge or other storage media in a mobile karaoke system comprising the following steps:
providing said mobile karaoke system with a mobile karaoke transmitter, a cartridge identification device and a block device, identifying an authorized cartridge and blocking data exchange upon detecting an unauthorized data storage medium by means of said block device, wherein all authorized cartridges are provided with a key identification and coding device having an access password.

22. Method for preventing unauthorized access, copying and use of data stored in an authorized cartridge for a mobile karaoke system comprising the following steps:
providing a mobile karaoke transmitter with an auxiliary decoder linked to said cartridge via an interface connector, wherein each cartridge has a key identification and coding device adapted to prevent unauthorized data access and to transfer an identification code of said cartridge to said interface connector, wherein said code protects said data via a password so that said data are compressed and protected by said password, wherein said code is known to an authorized manufacturer of said cartridges and said data are stored in a Read-Only-Memory of said cartridge, wherein said data together with said karaoke transmitter and said key identification and coding device represent a system which communicates via said interface connector and enables direct access to said data after performance of a successful check of key codes pre-stored in said auxiliary decoder and said key-coding device of said cartridge.
